## Europäisches Patentamt

## European Patent Office

## Office européen des brevets

(19)

(11) Numéro de publication: **0 099 278**
**B1**

(12) **FASCICULE DE BREVET EUROPEEN**

(45) Date de publication du fascicule du brevet:
**10.12.86**

(21) Numéro de dépôt: **83401170.2**

(22) Date de dépôt: **09.06.83**

(51) Int. Cl.⁴: **H 03 K 17/97**

(54) **Bouton poussoir étanche.**

(30) Priorité: **02.07.82 FR 8211625**

(43) Date de publication de la demande:
**25.01.84 Bulletin 84/4**

(45) Mention de la délivrance du brevet:
**10.12.86 Bulletin 86/50**

(84) Etats contractants désignés:
**BE CH DE GB IT LI NL SE**

(56) Documents cités:
**DE - A - 2 710 211**
**GB - A - 1 364 437**
**GB - A - 2 015 263**
**US - A - 3 719 902**

(73) Titulaire: **ETAT-FRANCAIS représenté par le DELEGUE GENERAL POUR L'ARMEMENT, Bureau des Brevets et Inventions de la Délégation Générale pour l'Armement 14, rue Saint-Dominique, F-75997 Paris Armées (FR)**

(72) Inventeur: **Cantegrel, Jean-Paul, 9, rue Savier, F-92240 Malakoff (FR)**

ACTORUM AG

## Description

La présente invention a pour objet un bouton poussoir étanche comprenant un bouton de commande maintenu dans une position de repos à l'aide d'un ressort par rapport à un corps en matière plastique et susceptible de venir dans une position de travail sous l'action d'une force extérieure opposée à l'action du ressort, pour modifier les caractéristiques d'un circuit électrique.

Lorsqu'un interrupteur d'un circuit électrique placé dans un boîtier étanche doit être commandé de l'extérieur du boîtier, il est nécessaire de disposer d'un organe de commande, tel qu'un bouton poussoir qui, tout en comportant un élément mobile capable d'actionner l'interrupteur, ou plus généralement de modifier des caractéristiques du circuit électrique, ne risque pas d'affecter l'étanchéité de l'ensemble contenant le circuit électrique.

Le problème est particulièrement critique lorsque l'ensemble étanche doit être placé dans un milieu fluide tel qu'un milieu marin à des profondeurs importantes où les pressions sont realtivement élevées.

Une solution classique consiste à utiliser un bouton poussoir présentant un axe actionnant l'interrupteur et un joint torique disposé autour de l'axe pour assurer une étanchéité. Cette solution ne s'est cependant pas avérée satisfaisante, notamment lorsque le bouton poussoir doit être actionné à de nombreuses reprises, car la fiabilité est alors très faible. On sait en effet qu'un joint torique peut être facilement endommagé s'il travaille d'une manière répétitive sous de fortes pressions.

On connaît également des contacts dits ILS comprenant un aimant permanent commandant un contact scellé dans une ampoule de verre. Ce type de contacts répond au problème de l'étanchéité mais s'avère inutilisable dans de nombreux cas du fait de l'influence perturbatrice que peut exercer l'aimant sur le circuit commandé ou d'autres éléments voisins du contact. Ainsi, on a observé que la présence d'un contact ILS engendre une erreur de 10° sur un compas magnétique situé à 20 cm.

Dans le brevet US-A 371 902, on décrit un bouton poussoir comprenant deux bobinages alignés axialement, couplés l'un à l'autre et coopérant avec un anneau métallique solidaire du bouton et dont le déplacement modifie le couplage des bobinages. Ces bobinages sont montés sur un noyau tandis que l'anneau est solidaire d'un poussoir mobile par rapport à un boîtier. L'inconvénient de ce dispositif réside dans le fait que l'étanchéité entre les pièces mobiles est difficile à réaliser.

La présente invention a précisément pour but de remédier aux inconvénients précités et vise à réaliser un bouton poussoir qui soit étanche vis à vis d'un milieu liquide tel que de l'eau, y compris à des profondeurs importantes (par exemple de l'ordre de 100 m) où les surpressions exercées sont non négligeables (par exemple de l'ordre de 10 bars).

L'invention vise encore à réaliser un bouton poussoir étanche qui soit de plus amagnétique et notamment n'apporte pas de perturbations sur des instruments tels qu'un compas magnétique placé à proximité du bouton poussoir.

Ces buts sont atteints grâce à un bouton poussoir étanche destiné à être fixé sur un boîtier support, comprenant un bouton de commande maintenu dans une position de repos à l'aide d'un ressort par rapport à un corps en matière plastique, le corps étant constitué d'une enveloppe extérieure et d'un noyau central délimitant entre eux un espace libre, le bouton présentant une partie inférieure métallique engagée partiellement dans l'espace libre lorsque le bouton est en position repos et capable de coulisser plus profondément dans ledit espace lorsque le bouton est en position de travail sous l'action d'une force extérieure opposée à l'action du ressort pour changer l'induction mutuelle entre un bobinage émetteur et un bobinage récepteur, caractérisé en ce que l'enveloppe et le noyau sont solidaires l'un de l'autre au niveau d'une paroi de fond, en ce que l'espace libre communique avec le milieu extérieur et est isolé de l'intérieur du boîtier support sur lequel l'enveloppe extérieure est rapportée de façon étanche, et en ce que dans la position de travail la partie métallique réalise un blindage entre le bobinage émetteur placé à l'intérieur d'une cavité pratiquée dans le noyau central et un bobinage récepteur placé à la périphérie de l'enveloppe extérieure, ces deux bobinages étant disposés en regard l'un de l'autre et en dehors de l'espace libre.

De façon plus particulière, l'espace libre dans lequel est engagée la partie inférieure métallique du bouton de commande est délimité par une première paroi cylindrique constituée par la périphérie du noyau central et une deuxième paroi cylindrique coaxiale constituée par un alésage formé dans l'enveloppe en matière plastique, et se termine à sa partie inférieure par une paroi de fond solidaire du noyau central ou de l'enveloppe extérieure et formant butée pour l'extrémité inférieure du bouton de commande.

Le bouton poussoir selon l'invention comprend un circuit électronique auquel sont raccordés les bobinages émetteur et récepteur, ledit circuit électronique étant disposé à l'intérieur d'un carter métallique sous l'ensemble constitué par le corps en matière plastique définissant l'espace libre, et lesdits bobinages.

Le circuit électronique est avantageusement moulé dans une résine d'enrobage à l'intérieur du carter métallique.

Selon un mode particulier de réalisation de l'invention, le bobinage émetteur est inclus dans un montage oscillateur qui engendre des impulsions de Dirac à temps de montée très bref avec une période de récurrence lente, le bobinage récepteur disposé à proximité du bobinage émetteur de manière à être excité par ce dernier lorsque le bouton de commande est en position de repos étant incorporé dans un circuit de détection, filtrage et amplification de l'oscillation du bobinage récepteur de manière à fournir un signal de tension continue à un niveau prédéterminé sur une borne de sortie.

D'autres caractéristiques et avantages de l'invention ressortiront de la description qui fait suite de modes particuliers de réalisation de l'invention, en référence au dessin annexé, sur lequel:

la fig. 1 est un schéma électrique montrant le fonctionnement d'un exemple de bouton poussoir étanche conforme à l'invention, et

la fig. 2 est une vue schématique en coupe axiale de la structure mécanique d'un exemple de bouton poussoir étanche conforme à l'invention.

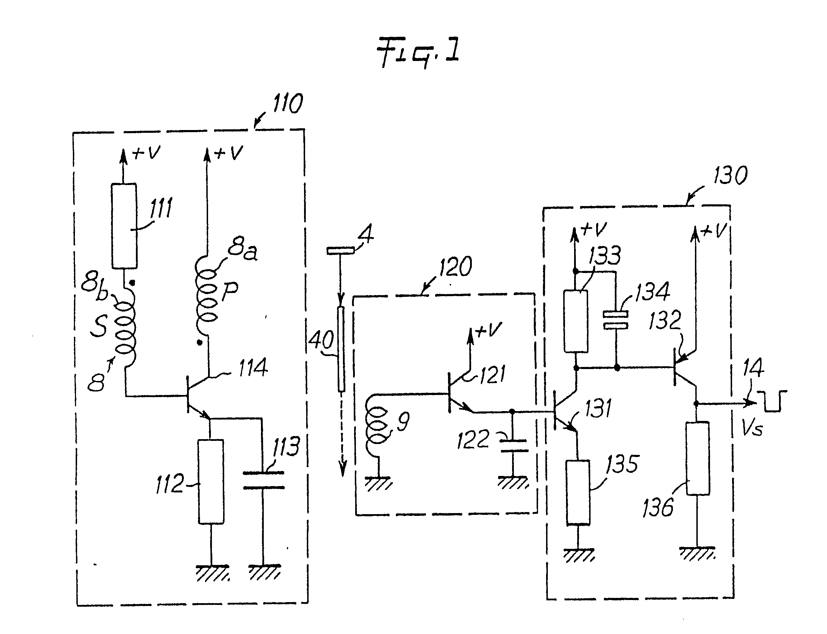

La figure 1 permet de comprendre le principe sur lequel est basé la présente invention qui utilise les lois de l'électromagnétisme. Le bouton poussoir comporte un capot 4 mobile prolongé par une partie métallique 40 capable de venir s'interposer entre deux bobinages 8, 9 afin de constituer un blindage. Lorsque le bouton poussoir est au repos (le capot mobile 4 étant relevé), il existe un couplage magnétique entre le premier bobinage 8 qui constitue un bobinage émetteur et le second bobinage 9 qui constitue un bobinage récepteur, de sorte qu'un signal apparaît en sortie du bobinage récepteur 9. La présence de ce signal caractérise ainsi la position de repos du bouton poussoir, pour laquelle le capot ou la touche 4 est relevé.

Lorsqu'une pression de commande est exercée sur le capot ou la touche 4, le blindage 40, qui constitue un prolongement de la partie du capot 4 sur laquelle est exercé l'effort de pression, est introduit entre les bobinages 8 et 9. Le couplage magnétique qui existait précédemment entre ces bobinages 8 et 9 est supprimé et le signal précédemment présent en sortie du bobinage récepteur 9 disparaît. L'absence de signal en sortie du bobinage récepteur 9 caractérise ainsi la commande faite sur le bouton poussoir.

Sur la figure 1 on voit un exemple de circuits électroniques adaptés pour provoquer de façon efficace une variation de niveau d'un signal de sortie $v_s$ sur une borne de sortie 14 en fonction de l'actionnement du bouton poussoir 4.

Un circuit émetteur 110 comprend un montage d'oscillateur bloqué adapté pour produire des impulsions de Dirac avec un temps de montée très bref et une période de récurrence lente, ces impulsions étant destinées à exciter la bobine du bobinage récepteur 9 lorsque le blindage 40 n'est pas interposé entre les bobinages 8 et 9. L'oscillateur 110 comprend le bobinage émetteur 8 formé d'une bobine primaire 8a montée entre une source d'alimentation +V et le collecteur d'un transistor 114, et une bobine secondaire 8b montée entre la base du transistor 114 et, par l'intermédiaire d'une résistance 111 à la source d'alimentation +V. L'émetteur du transistor 114 est par ailleurs relié à la masse par le montage en parallèle d'une résistance 112 et d'un condensateur 113.

Lorsque le blindage 40 n'est pas interposé entre le bobinage émetteur 8 et le bobinage récepteur 9, les impulsions produites par le circuit oscillateur 110 excitent la bobine du bobinage récepteur 9 qui oscille sur sa fréquence propre qui est déterminée par les valeurs de l'inductance du bobinage 9 et de la capacité parasite de ce bobinage 9.

Le circuit 120 constitue un étage de détection-filtrage et comprend un transistor 121 dont la base est reliée à l'extrémité du bobinage récepteur 9 non reliée à la masse, le collecteur est relié à la source d'alimentation +V et l'émetteur est relié à une borne d'un condensateur 122 dont l'autre borne est à la masse. La sortie de l'étage 120 de détection-filtrage est reliée à l'entrée d'un étage amplificateur 130 comprenant un premier transistor d'entrée 131 dont la base est reliée à la sortie de l'étage 120 de détection-filtrage, l'émetteur est relié à la masse par une résistance 135 et le collecteur est relié à l'alimentation +V par le montage parallèle d'une résistance 135 et d'un condensateur 134. Le collecteur du transistor 131 est en outre relié à la base d'un transistor complémentaire de sortie 132 dont l'émetteur est relié à l'alimentation +V et le collecteur est relié à la masse par une résistance 136.

La sortie 14 du circuit amplificateur 130 est prise sur le collecteur du transistor 132 et délivre un niveau continu de tension $V_s$ correspondant à un niveau logique «1» lorsque le bouton poussoir est au repos. Lorsque le blindage 40 est introduit entre les deux bobinages 8 et 9, la self du bobinage récepteur 9 n'est plus excitée et la tension de sortie $V_s$ sur la borne de sortie 14 devient nulle.

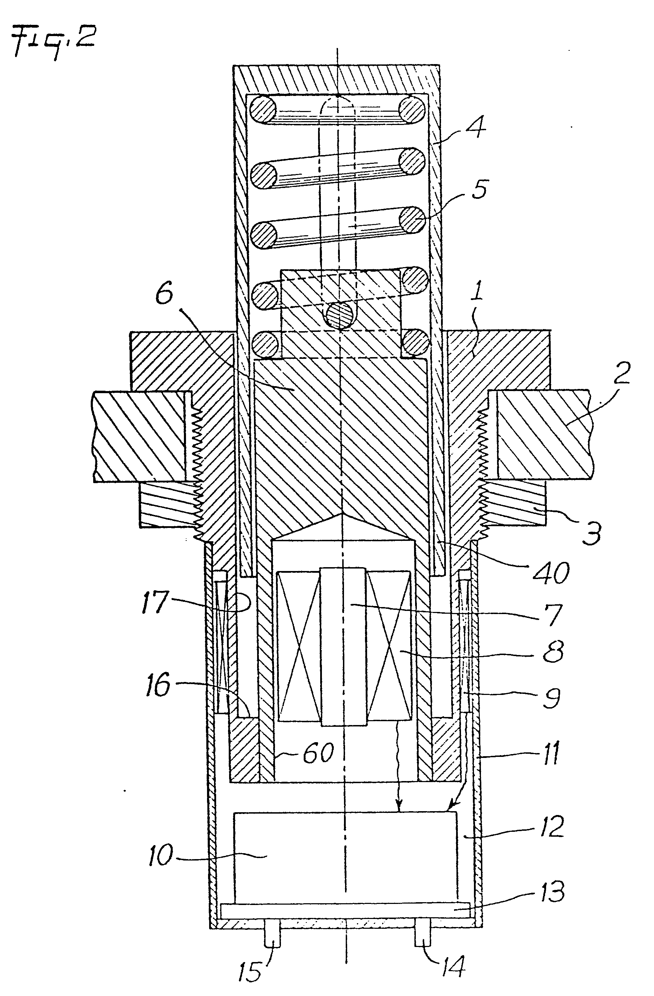

La figure 2 montre la structure mécanique d'un bouton poussoir utilisant le principe décrit ci-avant et garantissant une parfaite étanchéité entre le milieu extérieur dans lequel se trouve plongé le bouton poussoir et un espace interne comprenant und circuit électrique, de même que l'ensemble des éléments des étages 110, 120 et 130 du circuit de la figure 1, seuls les éléments mobiles 4 et 40 restant en contact avec le milieu extérieur.

Comme on peut le voir sur la figure 2, un bouton poussoir conforme à l'invention comprend un corps fixe 1, 6 isolant réalisé, par exemple en matière plastique, et formé d'une enveloppe extérieure 1 et d'un noyau central 6 définissant entre eux à partir de leurs faces supérieures extérieures en contact avec le milieu ambiant un espace libre 17 annulaire de faible largeur et de grande profondeur. L'enveloppe 1 et le noyau 6 sont reliés à leur partie inférieure afin de constituer un fond 16 pour l'espace libre 17. Les surfaces verticales de l'enveloppe 1 et du noyau 6 qui délimitent l'espace libre 17 peuvent présenter la forme de surfaces cylindriques coaxiales constituant d'une part un alésage formé dans l'enveloppe 1 et d'autre part la périphérie du noyau central 6.

La partie extérieure de l'enveloppe 1 est montée sur un support 2 constituant par exemple l'enceinte d'un boîtier étanche. Un écrou 3 assure le blocage de l'enveloppe 1 contre le support 2. Un carter métallique 11 par exemple en acier inoxydable est rapporté sur la paroi extérieure de l'enveloppe 1 à l'intérieur de l'espace défini par le support 2. Le carter 11 contient un circuit imprimé 13 portant des composants 10 du circuit électronique de la figure 1, éventuellement enrobés dans une résine, et disposés dans un espace libre ménagé à l'intérieur du carter 11 sous le noyau central 6 et l'enveloppe extérieure 1. Le circuit électronique 10 est relié par une borne de sortie 14 et une borne d'alimentation 15 qui traversent la paroi du carter 11, aux dispositifs commandés par le bouton poussoir et situés à l'intérieur du support 2. Une borne de masse peut également être présente.

Une cavité 60 formée à la partie inférieure du noyau central 6 comprend le bobinage émetteur 8 qui est monté sur un noyau ferromagnétique 7 et relié au circuit électronique 10. Le bobinage récepteur 9, également relié au circuit 10, est lui-même situé en regard du bobinage émetteur 8, mais à l'extérieur du noyau central 6 et de l'enveloppe 1, dans un espace ménagé entre l'enveloppe 1 et le carter 11. Les bobinages 8 et 9 sont disposés dans des emplacements tels que les parties du noyau central 6 et de l'enveloppe 1 qui leur font face sont séparées par la partie inférieure de l'espace libre annulaire 17.

Un capot cylindrique métallique 4 dont la partie supérieure sert de touche de manœuvre pour le bouton poussoir est engagé par sa partie libre inférieure 40 dans l'espace libre annulaire 17 contre l'action d'un ressort 5 qui est disposé entre la partie supérieure du noyau central isolant 6 et la face interne supérieure du capot 4 pour tendre, en l'absence d'action extérieure, à maintenir ce dernier dans une position telle que la partie inférieure métallique 40 du capot 4 reste placée au-dessus de la zone dans laquelle se trouvent disposés les bobinages émetteur et récepteur 8, 9. En l'absence d'effort extérieur de pression sur le capot 4, la partie de l'espace libre 17 située entre les bobinages 8 et 9 est dégagée et le couplage entre les bobinages 8 et 9 est effectif, de sorte que, comme cela a été expliqué plus haut, un signal de niveau haut est présent sur la borne de sortie 14. En revanche, lorsqu'un effort de pression est exercé sur le capot 4, la partie inférieure 40 du capot 4 vient en butée sur le fond 16 de l'espace libre 17 et forme un écran entre les bobinages émetteur 8 et récepteur 9, de sorte que le signal de sortie sur la borne 14 passe au niveau bas. Bien entendu, les niveaux du signal de sortie sur la borne de sortie 14 pourraient être inversés à l'aide d'un circuit inverseur incorporé dans le circuit 10 si l'on désire disposer d'un signal de sortie de niveau bas pour un état de repos du bouton poussoir et un signal de sortie de niveau haut lorsqu'une commande est exercée sur le bouton poussoir.

Les pièces 1 et 6 peuvent être monobloc ou réunies l'une à l'autre par exemple par collage. L'étanchéité reste dans tous les cas totale puisque l'espace libre 17 n'est jamais en communication avec l'intérieur du carter 11 ou, d'une manière générale, l'espace interne au support 2. Des moyens de retenue 18 peuvent en outre être prévus pour empêcher le capot 4 de se détacher du noyau 6.

## Revendications

1. Bouton poussoir étanche destiné à être fixé sur un boîtier support (2), comprenant un bouton de commande (4) maintenu dans une position de repos à l'aide d'un ressort (5) par rapport à un corps (1, 6) en matière plastique, le corps étant constitué d'une enveloppe extérieure (1) et d'un noyau central (6) délimitant entre eux un espace libre (17), le bouton (4) présentant une partie inférieure métallique (40) engagée partiellement dans l'espace libre (17) lorsque le bouton (4) est en position repos et capable de coulisser plus profondément dans ledit espace (17) lorsque le bouton (4) est en position de travail sous l'action d'une force extérieure opposée à l'action du ressort pour changer l'induction mutuelle entre un bobinage émetteur (8) et un bobinage récepteur (9), caractérisé en ce que l'enveloppe (1) et le noyau (6) sont solidaires l'un de l'autre au niveau d'une paroi de fond (16), en ce que l'espace libre (17) communique avec le milieu extérieur et est isolé de l'intérieur du boîtier support (2) sur lequel l'enveloppe extérieure (1) est rapportée de façon étanche, et en ce que dans la position de travail la partie métallique (40) réalise un blindage entre le bobinage émetteur (8) placé à l'intérieur d'une cavité (60) pratiquée dans le noyau central (6) et un bobinage récepteur (9) placé à la périphérie de l'enveloppe extérieure (1), ces deux bobinages étant disposés en regard l'un de l'autre et en dehors de l'espace libre (17).

2. Bouton poussoir selon la revendication 1, caractérisé en ce que l'espace libre (17, dans lequel est engagé la partie inférieure métallique (40) du bouton de commande (4) est délimités par la surface interne de l'enveloppe (1), la surface externe du noyau (6) toutes deux de révolution cylindrique, et la paroi de fond (16) reliant le noyau à l'enveloppe.

3. Bouton poussoir selon la revendication 1 ou revendication 2, caractérisé en ce qu'il comprend un circuit électronique (10) auquel sont raccordés les bobinages émetteur (8) et récepteur (9) et en ce que ledit circuit électronique est disposé à l'intérieur d'un carter métallique (11) sous l'ensemble constitué par le corps (1, 6) en matière plastique définissant l'espace libre (17), et lesdits bobinages (8, 9).

4. Bouton poussoir selon la revendication 3, caractérisé en ce que le circuit électronique (10) est moulé dans une résine d'enrobage (12) à l'intérieur du carter métallique (11).

5. Bouton poussoir selon l'une quelconque des revendications 1 à 4, caractérisé en ce que le bobinage émetteur (8) est inclus dans un montage oscillateur (110) qui engendre des impulsions de Dirac à temps de montée très bref avec une période de récurrence lente, et en ce que le bobinage récepteur (9) est disposé à proximité du bobinage émetteur (8) de manière à être excité par ce dernier lorsque le bouton de commande est en position de repos, est incorporé dans un circuit (120, 130) de détection, filtrage et amplification de l'oscillation du bobinage récepteur (9) de manière à fournir un signal de tension continue à un niveau prédéterminé sur une borne de sortie (14).

## Patentansprüche

1. Wasserdichter Druckknopf zur Befestigung auf einem Traggehäuse (2) mit einem Schaltknopf (4), der mittels einer Feder (5) in einer Ruhestellung im Vergleich zu einem Körper (1, 6) aus Kunststoff gehalten wird, wobei der Körper von einem Aussenmantel (1) und einem Zentralkern (6) gebildet wird, die untereinander einen freien Raum (17) begrenzen, und der Schaltknopf (4) einen unteren metallischen Teil (40) aufweist, der teilweise in den freien Raum (17) eingeführt ist, wenn der Schaltknopf (4) sich in der Ruhestellung befindet und tiefer in den vorgenannten Raum (17) hineingleiten kann, wenn der Schaltknopf (4), unter der Einwirkung einer der Federkraft entgegengerichteten äusseren Kraft, in die Arbeitsstellung gebracht wird, um die gegenseitige Induktion zwischen einer Senderwicklung (8) und einer Empfängerwicklung (9) zu ändern, dadurch gekennzeichnet, dass der Mantel (1) und der Kern (6) auf der Ebene einer Bodenwandung (16) fest miteinander verbunden sind, dass der freie Raum (17) mit der äusseren Umgebung in Verbindung steht und vom Innern des Traggehäuses (2) isoliert ist, auf das der Aussenmantel (1) in wasserdichter Weise aufgesetzt ist, und dass der metallische Teil (40) in der Arbeitsstellung eine Abschirmung zwischen der im Innern eines in dem Zentralkern (6) vorgesehenen Hohlraumes (60) angebrachten Senderwicklung (8) und einer am Umfang des Aussenmantels (1) angeordneten Empfängerwicklung (9) bewirkt, wobei diese beiden Wicklungen einander gegenüberstehend und ausserhalb des freien Raumes (17) angeordnet sind.

2. Druckknopf nach Anspruch 1, dadurch gekennzeichnet, dass der freie Raum (17), in den der untere metallische Teil (40) des Schaltknopfes (4) eingeführt ist, durch den Aussenmantel (1), die Aussenfläche des Kernes (6), welche beide eine rotationszylindrische Form aufweisen, und die den Kern mit dem Mantel verbindende Bodenwandung (16) begrenzt wird.

3. Druckknopf nach einem der Ansprüche 1 oder 2, dadurch gekennzeichnet, dass er einen elektronischen Schaltkreis (10) umfasst, an den die Senderwicklung (8) und die Empfängerwicklung (9) angeschlossen sind, und dass der vorgenannte elektronische Schaltkreis im Innern eines metallischen Gehäuses (11), unter der von dem den freien Raum (17) definierenden Körper (1) aus Kunststoff und den vorgenannten Wicklungen (8, 9) gebildeten Einheit, angeordnet ist.

4. Druckknopf nach Anspruch 3, dadurch gekennzeichnet, dass der elektronische Schaltkreis (10) im Innern des metallischen Gehäuses (11) in einem Einbettungsharz vergossen ist.

5. Druckknopf nach einem der vorstehenden Ansprüche 1 bis 4, dadurch gekennzeichnet, dass die Senderwicklung (8) einem Schwingkreis (110) angehört, der Dirac-Impulse mit sehr kurzer Anstiegzeit und langsamer Impulsfolge erzeugt, und dass die Empfängerwicklung (9) in der Nähe der Senderwicklung (8) derart angeordnet ist, dass sie von dieser letzteren erregt wird, wenn der Schaltknopf sich in der Ruhestellung befindet, und in einen Schaltkreis (120, 130) zur Erfassung, Filterung und Verstärkung der Oszillation der Empfängerwicklung derart eingegliedert ist, dass ein Gleichspannungssignal auf einem vorgegebenen Niveau auf eine Ausgangsklemme (14) gegeben wird.

## Claims

1. Sealed key switch to be fastened to a support box, including a control button held by a spring in rest position with respect to a plastic body, the body consisting of an outer casing and a central core with an empty space between them, the button having a metal lower part fitting partially into the open space when the button is in Off position and that can slide deeper into the space when the button is placed in On position by an external force opposing the spring action to change the mutual induction between a transmitter coil and a receiver coil, wherein the casing and the core are integral with each other at the level of the bottom wall, wherein the empty space communicates with the outside environment and is isolated from the inside of the support box on which the outer casing is fitted, sealed, and wherein the metal part provides a shield between the transmitter coil, placed in a cavity in the central core, and a receiver coil around the edge of the outer casing, both coils facing each other and outside the empty space.

2. Key switch claimed in claim 1, wherein the empty area in which the lower metal part of the control button fits is delimited by the inner surface of the casing and the outer surface of the core, both being cylinders of revolution, and the base wall connecting the core to the casing.

3. Key switch as claimed in claim 1 or 2, wherein it includes an electronic circuit to which the transmitter and receiver coils are connected, and wherein the said electronic circuit is placed inside a metal casing under the assembly consisting of the plastic body defining the empty space, and the said coils.

4. Key switch as claimed in claim 3, wherein the electronic circuit is molded in a resin encasement inside the metal casing.

5. Key switch as claimed in any one claim 1 to 4, wherein the transmitter coil is included in an oscillator circuit creating Dirac pulses with very short positive-going transition time and long repetition period, and wherein the receiver coil is placed near the transmitter coil so as to be excited by the transmitter when the key switch is off position, and is incorporated in a circuit that detects, filters and amplifies the receiver coil oscillation to deliver a continuous signal at a preset level on a terminal output.

Fig.1

Fig.2